(19) Europäisches Patentamt / European Patent Office / Office européen des brevets

(11) **EP 2 978 869 B1**

(12) **EUROPÄISCHE PATENTSCHRIFT**

(45) Veröffentlichungstag und Bekanntmachung des Hinweises auf die Patenterteilung:
**03.01.2024 Patentblatt 2024/01**

(21) Anmeldenummer: **14713764.0**

(22) Anmeldetag: **26.03.2014**

(51) Internationale Patentklassifikation (IPC):
**C23C 14/00** (2006.01)   **C23C 14/06** (2006.01)
**C23C 14/34** (2006.01)   **C23C 28/00** (2006.01)
**C23C 28/04** (2006.01)

(52) Gemeinsame Patentklassifikation (CPC):
**C23C 14/3492; C23C 14/0042; C23C 14/0084; C23C 14/0641; C23C 14/0676; C23C 28/042; C23C 28/044; C23C 28/42; C23C 28/44**

(86) Internationale Anmeldenummer:
**PCT/EP2014/000811**

(87) Internationale Veröffentlichungsnummer:
**WO 2014/154356 (02.10.2014 Gazette 2014/40)**

(54) **HARTSTOFFSCHICHTEN MIT AUSGEWÄHLTER WÄRMELEITFÄHIGKEIT**

HARD MATERIAL LAYERS WITH SELECTED THERMAL CONDUCTIVITY

COUCHES EN MATÉRIAU DUR PRÉSENTANT UNE CONDUCTIVITÉ THERMIQUE DÉFINIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.03.2013 DE 102013005437**

(43) Veröffentlichungstag der Anmeldung:
**03.02.2016 Patentblatt 2016/05**

(73) Patentinhaber:
• **Oerlikon Surface Solutions AG, Pfäffikon**
  **8808 Pfäffikon SZ (CH)**
• **ETH Zürich**
  **8092 Zürich (CH)**
• **EMPA Dübendorf**
  **8600 Dübendorf (CH)**

(72) Erfinder:
• **SOBIECH, Matthias Lukas**
  **88142 Wasserburg (DE)**
• **STEIN, Sebastian**
  **77855 Achern (DE)**
• **BÖTTGER, Paul Heinrich Michael**
  **A-4020 Linz (AT)**

• **SHKLOVER, Valery**
  **8006 Zürich (CH)**
• **PATSCHNEIDER, Jörg**
  **8706 Meilen (CH)**

(74) Vertreter: **Misselhorn, Hein-Martin**
**Patent- und Rechtsanwalt**
**Am Stein 10**
**85049 Ingolstadt (DE)**

(56) Entgegenhaltungen:
EP-A1- 2 107 134        EP-A2- 0 947 607
WO-A2-2011/036246       CN-A- 102 586 731
DE-A1-102010 052 687    JP-A- 2001 198 709
JP-A- 2004 106 103

• **FRANK BARTHELMÄ ET AL: "Oxygen-Improved Hard Coatings for High Performance Cutting Processes", PROCEDIA CIRP, Bd. 1, Nr. 1, 1. Januar 2012 (2012-01-01), Seiten 208-213, XP055119914, ISSN: 2212-8271, DOI: 10.1016/j.procir.2012.04.036**

**Beschreibung**

Die vorliegende Erfindung betrifft ein Hartstoffschichtsystem mit zumindest einer Oxynitrid-Hartstoffschicht mit vorgegebener Wärmeleitfähigkeit. Weiterhin betrifft die vorliegende Erfindung eine Methode zur Herstellung von Oxynitrid-Hartstoffschichten mit ausgewählter Wärmeleitfähigkeit, die insbesondere für die spangebende Bearbeitung von schwerzerspanbaren Werkstoffen, zum Beispiel Nickel- und/oder Titan-basierten Legierungen, geeignet sein können.

**Stand der Technik**

Ti-basierte Werkstoffe weisen im Vergleich zu Al-basierten Werkstoffen oder niedrig und unlegierten Stählen eine bedeutend geringere Wärmeleitfähigkeit auf. Hinzu kommt, dass die Zugfestigkeit Ti-basierter Werkstoffe deutlich höher ist. Bedingt durch die geringe Wärmeleitfähigkeit von A = 4 bis 16 W/mK spielt der Wärmeabtransport während des Spanentstehungsprozesses bei der Zerspanung eine grosse Rolle. So geht beispielsweise bei der Bearbeitung von Ti-basierten Werkstoffen rund 30% mehr Energie ins Werkzeug im Vergleich zur Bearbeitung von CK45 unter ansonsten gleichen Prozessparametern. Dies führt zu einer erhöhten thermischen Belastung des Schneidwerkzeuges und somit zu einer Begünstigung des Werkzeugverschleißes. Im Umkehrschluss werden die Technologieparameter zur Bearbeitung Ti-basierter Werkstoffe gesenkt, so dass die Produktivität und somit die Wirtschaftlichkeit bei der Bearbeitung von Ti-basierten Werkstoffen deutlich geringer sind als bei anderen Werkstoffen

Ni-basierte Werkstoffe wie etwa Inconel weisen eine hohe Temperaturbeständigkeit auf und sind daher insbesondere im Turbinenbau häufig anzutreffen. Hinzu kommt, dass auch bei höchsten Temperaturen eine ausreichende Festigkeit des Werkstoffs gegeben ist.

Durch die allgemein hohen Anforderungen an die Zerspanprozesse zur Bearbeitung von Ti- und Ni-basierten Werkstoffen, sind die Technologieparameter vergleichsweise gering und damit auch die Produktivität und die Wirtschaftlichkeit der Verfahren niedrig.

Ausserdem führt die resultierende hohe thermische Belastung im Zerspanprozess zu Kammrissbildung und/oder Kolkverschleiss, was zusätzlich den abrasiven Verschleissmechanismus an den aktiven Oberflächen der Zerspanwerkzeugen begünstigt. Adhäsiver Verschleiss und plastische Deformation des Schneidstoffes werden je nach Werkstoff ebenfalls beobachtet.

Zudem zeigen aktuelle Untersuchungen, dass rein AlCrN-basierte als auch rein AlTiN-basierte Schichtsysteme ähnlichen Verschleissmechanismen unterliegen wie die Oberflächen von unbeschichteten Substraten und dadurch keines der beiden Schichtsysteme einen erheblichen Vorteil erbringt.

Trotzdem werden gemäss dem Stand der Technik einige Hartstoffschichten auf Oxynitridbasis als gut geeignet für die spangebende Bearbeitung von schwerzerspanbaren Materialien angesehen.

Das Patentdokument JP2012192513A offenbart zum Beispiel ein beschichtetes Zerspanungswerkzeug, dessen Beschichtung eine erhöhte Performance bei der nassen spangebenden Bearbeitung von schwerzerspanbaren Werkstoffen, wie z.B.

Titan-basierten Legierungen, ermöglicht. Die Beschichtung besteht aus einer inneren und einer äusseren Lage, wobei die innere Lage eine Oxynitridschicht aus Titan und Aluminium mit einer Schichtdicke zwischen 0.5 und 3.4 $\mu$m ist, und die äussere Lage eine Nitridschicht aus Titan und Aluminium mit einer Schichtdicke zwischen 0.8 und 4.0 $\mu$m ist. Die Oxydnitridschicht umfasst Mikroporen, die der Schichtdicke entlang verteilt sind und einen Durchmesser zwischen 0.1 und 1.5 $\mu$m aufweisen. Ausserdem entspricht die Zusammensetzung einer solchen Oxidschicht der folgenden Beziehung in Atomprozent: $(Ti_{1-x}Al_x)N_{1-y}O_y$ mit x zwischen 0.4 und 0.75 und y zwischen 0.1 und 0.4.

Auch das Patentdokument JP2009167498A bezieht sich auf Oxynitrid-Randschichten. In diesem Fall werden die Oxynitrid- Randschichten durch anodische Oxidation des Substrats mit Schichtdicken von 5 bis 30 $\mu$m hergestellt. Auch das Risiko von Schichtabplatzungen durch zu hohe Druckeigenspannungen wird hierdurch reduziert. Die Zusammensetzung solcher Schichten wird durch die folgende Beziehung in Atomprozent definiert: $(Me_{1-a}X_a)_a(N_{1-x-y}C_xO_y)$, wobei Me ein oder mehrere Elemente aus den Gruppen 4a, 5a und 6a der Elementen im Periodensystem ausgewählt ist, X ein oder mehrere Elemente aus der Gruppe Al, Si, B und S ausgewählt ist, $0.10 \leq a \leq 0.65$, $0 \leq x \leq 10$, $0 \leq y \leq 10$ und $0.85 \leq \alpha \leq 1,25$. Ausserdem sollen solche Randschichten eine flächenzentrierte kubische Struktur aufweisen. Weiterer relevanter Stand der Technik ist in dem Patentdokument CN 102 586 731 A offenbart.

Jedoch offenbart der Stand der Technik nicht, wie man PVD Oxynitrid-Hartstoffschichten mit vorgegebener Wärmeleitfähigkeit herstellen kann.

**Aufgabe der vorliegenden Erfindung**

Es ist Aufgabe der vorliegenden Erfindung eine Methode bereitzustellen, um Oxynitrid-Hartstoffschichten herzustellen, die eine vorgegebene Wärmeleitfähigkeit aufweisen. Weiterhin ist es auch Aufgabe der vorliegenden Erfindung ein Hartstoffschichtsystem bereitzustellen, das solche Oxynitrid-Hartstoffschichten umfasst. Vorzugsweise sollen diese Oxynitrid-Hartstoffschichten insbesondere eine höhere Verschleissbeständigkeit bei hohen Temperaturen aufweisen, so dass diese Hartstoffschichten insbesondere für die spangebende Bearbeitung von schwerzerspanbaren Werkstoffen gut geeignet sein können.

Insbesondere wird es erzielt eine Methode bereitzustellen, die eine Beschichtung mit hoher Temperaturbeständigkeit, verringerter Wärmeleitfähigkeit, erhöhter Anisotropie der Wärmeleitfähigkeit und somit erhöhter Lebensdauer ermöglicht, so dass eine Steigerung der Produktivität bei der spangebenden Bearbeitung von schwerzerspanbaren Werkstoffen ermöglicht wird.

**Beschreibung der vorliegenden Erfindung**

Die Aufgabe der vorliegenden Erfindung wird dadurch gelöst, in dem eine Methode zur Herstellung von harten Oxynitrid-Hartstoffschichten mit einer vorgegebenen Wärmeleitfähigkeit, wie im Anspruch 13 oder 14 beschrieben, bereitgestellt wird. Ausserdem betrifft die vorliegende Erfindung Hartstoffschichtsysteme gemäss den Ansprüchen 1 bis 10, die Bereitstellung eines beschichteten Werkzeugs gemäss dem Anspruch 11 und seine Verwendung gemäss dem Anspruch 12.

Gemäss der vorliegenden Erfindung können harten Oxynitridschichten mit vorgegebener Wärmeleitfähigkeit insbesondere unter Verwendung der PVD-Technologie hergestellt werden. Unter dem Begriff PVD-Technologie sind Oberflächenveredelungsverfahren zusammengefasst, bei denen der Schichtwerkstoff über die Gasphase zur zu beschichtenden Substratoberfläche transportiert wird. In den meisten Fällen werden die einzelnen Verfahren nach der Art der Energieeinbringung unterschieden in Bedampfen, Sputtern und Ionenplattieren. Diesen Verfahren lassen sich wiederum in gewisse Unterverfahren und Varianten einordnen. Für die Beschichtung von Bauteil- und Werkzeugoberflächen, die bei der Anwendung stark tribologisch beansprucht werden, haben sich insbesondere PVD-Verfahren der Sorte Magnetron-Sputtern und/oder Lichtbogenverdampfen gut etabliert.

Gemäss der vorliegenden Erfindung wird die Wärmeleitfähigkeit in der Hartstoffschicht durch die Zugabe von Sauerstoff während des Schichtabscheidungsprozesses beeinflusst und somit wie gewünscht eingestellt.

Die grundlegenden Zusammenhänge werden im Folgenden beispielhaft an Hand von zwei im Detail untersuchten Schichtsystemen Titanoxynitrid ($Ti_aO_cN_{b-c}$) und Chromoxynitrid ($Cr_dO_fN_{e-f}$) beschrieben: Ausgehend von jeweils reinem Titannitrid ($Ti_aN_b$) oder reinem Chromnitrid ($Cr_dN_e$) kann durch kontrollierte Sauerstoffzugabe sowohl die kubische Phase als auch der Anteil an metallischen Elementen bezogen auf den Anteil an nichtmetallischen Elementen (Metall/Nicht-Metall) in Atomprozent in der Schicht erhalten bleiben. Dies ist möglich, weil der Sauerstoff gegen den Stickstoff im Gitter im Verhältnis 1:1 ausgetauscht wird. Dieser Zusammenhang konnte durch EDX und XRD Messungen belegen werden.

Die Sauerstoffzugabe wurde mittels konventionellen Flow-Controllers derart gesteuert, dass der Sauerstoffanteil in der Oxynitridschicht kontinuierlich gesteigert wurde bis die gewünschte Wärmeleitfähigkeit erreicht werden konnte.

Gemäss der vorliegenden Erfindung soll der Sauerstoffanteil in einer Oxynitridschicht vorzugsweise einen Wert von 30 at% nicht überschreiten.

Mittels Rockwell-Indentation, Mikro-Indentation, Rasterelektronmikroskopie (REM) und Röntgendiffraktometrie (XRD; Untersuchungen sowohl bei Raumtemperatur als auch bei erhöhten Temperaturen) konnte gezeigt werden, dass sich die Schichteigenschaften in Bezug auf Schichthaftung, Schichthärte, E-Modul, Schichtmorphologie, Korngrösse, Phasenbestand und strukturelle Stabilität nicht signifikant ändern, d.h. die "eingestellten" positiven (Performance-relevanten) Schichteigenschaften werden durch $O_2$-Zugabe im Schichtzusammensetzungsbereich von 0 bis 30 at.% $O_2$ nicht signifikant verändert. Die Wäremleitfähigkeit der untersuchten Schichten wurde mittels der Cahills Methode ermittelt.

Die $O_2$-Zugabe im Schichtzusammensetzungsbereich von 0 bis 30 at.% $O_2$ hat signifikanten Einfluss auf die Wärmeleitfähigkeit der Schicht.

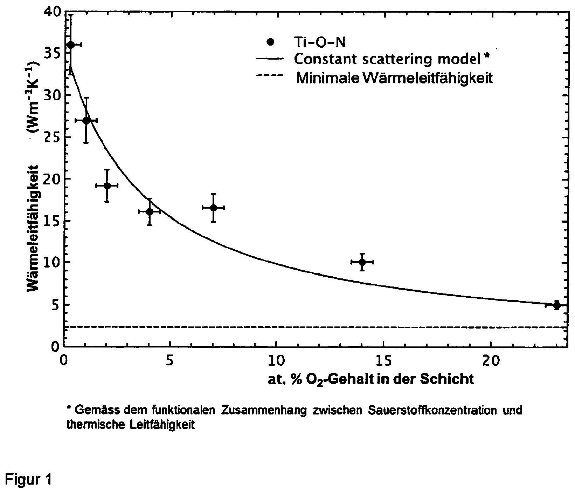

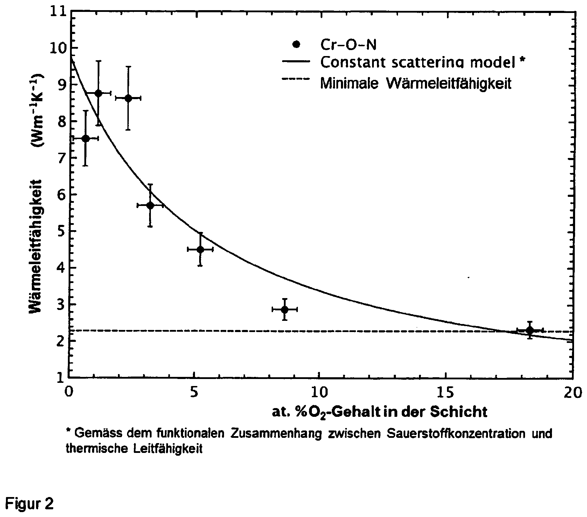

In den Figuren 1 und 2 ist der Zusammenhang zwischen dem Sauerstoffgehalt in der Schicht und der thermischen Leitfähigkeit der Schicht (gemessen von der Schichtoberfläche aus) für die Schichtsysteme Ti-O-N und Cr-O-N dargestellt.

Für diese Experimente wurden die Schichten mittels Lichtbogenverdampfung-PVD-Techniken abgeschieden. Die Substrattemperatur und der gesamten Druck in der Beschichtungskammer während der Beschichtungsprozesse wurden entsprechend bei ca. 450 °C und 2 Pa konstant gehalten. Stickstoff und Sauerstoff wurden entsprechend als Reaktivgas für die Abscheidung der Nitrid- und Oxydnitridschichten verwendet.

Dieses Verhalten konnten für beide Systemen mittels "constant scattering model" mathematisch beschrieben werden wie in den Figuren 1 und 2 gezeigt wird. Das ist ein Hinweis für die Allgemeingültigkeit dieses Verhaltens. Die Zugabe von $O_2$ verändert dabei den Streuquerschnitt, d.h. mit $O_2$-Zugabe werden zunehmend Gitterdefekte erzeugt, die die Ausbreitung von Gitterschwingungen (Phononen) stören.

Das Ersetzen von Stickstoff durch Sauerstoff erzeugt in Nitriden durch den unterschiedlichen Radius, die unterschiedliche Anzahl Valenzelektronen und die höhere Elektronegativität große Unordnung in der Materialstruktur. Defekte wie z. B. leere Gitterplätze, besetzte Zwischengitterplätze, Gitterversetzungen und Gitterverzerrungen sind möglich. Alle diese Defekte wirken sich negativ auf die Ausbreitung der Phononen in der Kristallstruktur aus und verringern damit potenziell die thermische Leitfähigkeit des Materials. In der Summe kann der Einfluss aller Defekte auf die thermische Leitfähigkeit, die ein Sauerstoffatom durchschnittlich erzeugt, als Phononen-Streuquerschnitt des Sauerstoffs verstanden werden. So lange sich die Kristallstruktur des Materials nicht fundamental ändert und keine zusätzlichen Oxidphasen neben dem Nitrid entstehen, kann von einem konstanten (vom Sauerstoffgehalt unabhängigen) Streuquerschnitt ausgegangen werden. Dies erlaubt das Einstellen der thermischen Leitfähigkeit über den Sauerstoffgehalt. Der funktionale Zusammenhang wird beschrieben durch

$$\kappa(\chi) = \kappa_0 / (1 + a \cdot \chi)$$

Dabei ist $\kappa(\chi)$ die sauerstoffabhängige thermische Leitfähigkeit des Materials, $\kappa_0$ die thermische Leitfähigkeit im sauerstofffreien Material, $\chi$ die Sauerstoffkonzentration und $a$ ein Parameter, der den Streuquerschnitt enthält. Um den Parameter $a$ zu finden, muss eine Reihe von Proben mit unterschiedlichem Sauerstoffgehalt hergestellt und die thermische Leitfähigkeit gemessen werden. Die Anpassung der Funktion $\kappa(\chi)$ an die Daten liefert a.

Konkret wird gemäss der vorliegenden Erfindung vorgeschlagen Al-reiche AlTiN- und AlCrN-basierte Beschichtungen mit kontrollierten $O_2$-Gehalten, bevorzugt im Bereich von 0-30 at.% $O_2$, besonders bevorzugt im Bereich von 3 bis 25 at.% $O_2$, für die Zerspanung von Ti- und Ni-Basislegierungen unter Berücksichtigung einer Kombination mit weiteren Legierungselemente, wie Si, B, W, Nb, Y, Mo, Ni, zu verwenden.

Durch die kontrollierte $O_2$-Zugabe werden diese Schichtsysteme für bestimmte Anwendungen optimiert indem ein gezieltes Wärmeleitfähigkeitsverhalten innerhalb der Schicht erzeugt wird. Bevorzugt wird die Wärmeleitfähigkeit senkrecht zur Schicht minimiert (so niedrig wie möglich gemacht) und die Wärmeleitfähigkeit parallel zur Schicht wird maximiert (so hoch wie möglich gemacht), d.h. die Anisotropie der Wärmeleitfähigkeit wird maximiert

Die $O_2$-Konzentration sollte nicht so hoch sein, dass die mechanischen, chemischen und strukturellen Eigenschaften des Schichtsystems signifikant verändert werden bzw. negativ beeinflusst werden.

Vorzugsweise wird eine Härte des Schichtsystems grösser 20 GPa, noch vorzugsweise grösser 30 GPa erzielt.

Eine Ausführungsform der vorliegenden Erfindung ist ein Schichtsystem aus Ti-Al-N-O oder Cr-Al-N-O, wobei die Sauerstoffkonzentration innerhalb der Schicht in Richtung Schichtdicke gradiert wird.

Die vorliegende Erfindung ist ein Schichtsystem bei der mehrere Lagen mit erhöhter und reduzierter Sauerstoffkonzentration alternierend als mehrlagige (Multilayer) Struktur abgeschieden wird.

Der Einsatz von Gradierungen kann wie folgt verstanden werden: $O_2$-Gehalt wird senkrecht zur Substratoberfläche variiert entsprechend den Anforderungen.

Der Einsatz von Mehrlagenschichtsystemen kann wie folgt verstanden werden: $O_2$-reiche AlTiN-Lage folgt auf $O_2$-freie AlTiN-Lage umso gezielt die Wärmeleitfähigkeit parallel zum Substrat zu erhöhen und senkrecht dazu zu erniedrigen. Das Resultat ist ein optimierter Wärmeabtrag in den Span, d.h. somit aus dem Schicht/Substrat-System heraus.

Der Einsatz von Mehrlagenschichtsystemen kann auch wie folgt verstanden werden: Wechselfolge von AlCrN und AlTiN jeweils mit oder ohne $O_2$ um Anisotropie in Wärmeleitfähigkeit entsprechend den Erläuterungen von oben zu optimieren unter Berücksichtigung einer Kombination mit weiteren Legierungselemente, wie Si, B, W, Nb, Y, Mo, Ni.

Insbesondere betrifft die vorliegende Erfindung eine Methode zur Herstellung von Metalloxydnitrid-Hartstoffschichten durch PVD-Techniken in einer Vakuumkammer, wobei die Hartstoffschicht eine Zusammensetzung in Atomprozent $Me_p O_n N_m$ mit p+n+m=100% und eine vorgegebene Wärmeleitfähigkeit aufweist: Eine Methode gemäss der vorliegenden Erfindung kann folgenderweise durchgeführt werden:

a. Die metallischen Elemente der Metalloxydnitrid-Hartstoffschicht werden durch physikalische Gasphasenabscheidung aus mindestens einem Target abgeschieden, wobei das Target Me umfasst und Me zumindest ein Metall aus der Gruppe Ti, Zr, Hf, V, Nb, Ta, Cr, Mo, W und Al ist, und vorzugsweise Me auch zumindest ein Element aus der Gruppe Y, Ni, B und Si umfasst, wobei das Target für die Abscheidung von zumindest drei Schichten in verschiedenen Prozessen aber unter Verwendung der gleichen Prozessparameter mit Ausnahme von der Zusammensetzung des Reaktivgases verwendet wird.

b. Stickstoff wird als Reaktivgas für die Abscheidung einer ersten Referenzschicht verwendet, die eine Metallnitridschicht $Me_{p1} O_{n1} N_{m1}$ mit einer Sauerstoffkonzentration in Atomprozent $O_2$-conc1 = n1 = 0 ist, wobei die erste Referenzschicht bei einer konstanten Substrattemperatur Ts und einem konstanten gesamten Beschichtungsdruck P abgeschieden wird.

c. Stickstoff und Sauerstoff werden als Reaktivgas für die Abscheidung einer dritten Referenzschicht verwendet, die eine Metalloxydnitridschicht $Me_{p3} O_{n3} N_{m3}$ mit einer Sauerstoffkonzentration in Atomprozent $O_2$-conc3 = n3 von maximal 30 % ist, bevorzugt $O_2$-conc3 zwischen 20 und 30 %, wobei die dritte Referenzschicht bei der gleichen konstanten Substrattemperatur Ts und dem gleichem konstanten gesamten Beschichtungsdruck P wie bei der Abscheidung der ersten Referenzschicht abgeschieden wird und p1=p3 und p1/(m1+n1) = p1/(m3+n3).

d. Stickstoff und Sauerstoff werden als Reaktivgas für die Abscheidung einer zweiten Referenzschicht verwendet, die eine Metalloxynitridschicht $Me_{p2} O_{n2} N_{m2}$ mit einer Sauerstoffkonzentration in Atomprozent $O_2$-conc2 = n2, die grösser als $O_2$-conc1 und kleiner als $O_2$-conc3 ist, vorzugsweise

$O_2$-conc1 zwischen 5 und 20 %, wobei die zweite Referenzschicht bei der gleichen konstanten Substrattemperatur Ts und dem gleichem konstanten gesamten Beschichtungsdruck P wie bei der Abscheidung der ersten und dritten Referenzschicht abgeschieden wird und p1=p3=p2 und p1/(m1+n1) = p3/(m3+n3) = p2/(m2+n2).

e. Die Wärmeleitfähigkeit der ersten, zweiten und dritten Referenzschicht ausgehend von der Schichtoberfläche jeder Schicht wird gemessen.

f. Mit den gemessenen Werten von thermischer Leitfähigkeit und Sauerstoffkonzentration der ersten, zweiten und dritten Referenzschichten wird eine Korrelation der Form:

$$\kappa(\chi) = \kappa_0 \, / \, (1 + \alpha.\chi)$$

ermittelt, wobei

$\kappa(\chi)$ die sauerstoffabhängige thermische Leitfähigkeit des Hartstoffschichtsystems Me-O-N ist,

$\kappa_0$ die thermische Leitfähigkeit der ersten Referenzschicht ist,

$\chi$ die Sauerstoffkonzentration ist, und

$\alpha$ ein Parameter, der den Streuquerschnitt enthält, und der durch die Anpassung der Funktion $\kappa(\chi)$ an die Daten geliefert wird, ist.

g. Mit der Korrelation wird berechnet bei welcher Sauerstoffkonzentration in der $Me_pO_nN_m$ Hartstoffschicht eine vorgegebene thermische Leitfähigkeit erreicht wird, und es wird berechnet bei welcher Sauerstoffkonzentration des Reaktivgases der Beschichtungsprozesses im Schritt h durchgeführt werden muss.

h. Die $Me_pO_nN_m$ Hartstoffschicht wird mit der vorgegebenen thermischen Leitfähigkeit bei der gleichen Prozessparametern wie die Referenzschichten abgeschieden mit Ausnahme von der Sauerstoffkonzentration des Reaktivgases, die gemäss dem im Schritt g ermittelten Wert zuerst angepasst werden muss.

Ausserdem betrifft die vorliegende Erfindung Hartstoffschichtsysteme, die auf Substratoberflächen abgeschieden werden und die zumindest eine gemäss der oben beschriebenen Methode hergestellte $Me_pO_nN_m$ Hartstoffschicht umfassen.

Vorzugsweise umfasst die $Me_pO_nN_m$ Hartstoffschicht eines Hartstoffschichtsystems gemäss der vorliegenden Erfindung eine kubische Struktur, vorzugsweise umfasst Me zumindest grösstenteils Titan und Aluminium oder Chrom und Aluminium.

Vorzugsweise ist das Konzentrationsverhältnis in Atomprozent von Ti in Bezug auf Al, d.h. Ti/Al oder von Cr in Bezug auf Al, d.h. Cr/Al kleiner als 1.

Eine besondere Ausführungsform eines Hartstoffschichtsystems gemäss der vorliegenden Erfindung weist eine gradierte Sauerstoffkonzentration auf, zumindest einer Teil der Schichtdicke entlang.

Eine besonders bevorzugte Ausführungsform eines Hartstoffschichtsystems gemäss der vorliegenden Erfindung weist zumindest einer Teil der Schichtdicke entlang eine mehrlagige Struktur mit alternierenden A Schichten mit Zusammensetzung $Me_{ApA}O_{nA}N_{mA}$ und B Schichten mit Zusammensetzung $Me_{BpB}O_{nB}N_{mB}$ auf, wobei $Me_A = Me_B$, $p_A = p_B$, $n_A < n_B$ und $p_A/(n_A+m_A) = pB/(n_B+m_B)$.

Eine bevorzugte Variante der oben beschriebenen Ausführungsform eines Hartstoffschichtsystems ist durch A Schichten mit na = 0 gekennzeichnet.

Ein Hartstoffschichtsystem gemäss der vorliegenden Erfindung ist derart hergestellt, dass die Wärmeleitfähigkeit parallel zur Substratoberfläche grösser als die die Wärmeleitfähigkeit senkrecht zur Substratoberfläche ist.

Für bestimmte Anwendungen, beispielsweise für die Umformung und für die Zerspanung bestimmter Werkstoffe, ist die Verwendung eines Hartstoffschichtsystems gemäß der vorliegenden Erfindung besonders von Vorteil, wenn es mindestens eine Härte grösser 20 GPa aufweist, vorzugsweise grösser 30 GPa. Mit einem Hartstoffschichtsystem gemäss der vorliegenden Erfindung können auch jegliche Bauteile und Werkzeuge. Insbesondere sind beschichtete Zerspanungswerkzeuge mit einer Beschichtung gemäss der vorliegenden Erfindung für die spangebende Bearbeitung von schwerzerspanbaren Materialien wie zum Beispiel Ni- und Ti-basierten Legierungen vielversprechend.

**Patentansprüche**

1.  Hartstoffschichtsystem abgeschieden auf einer Substratoberfläche mit einer mehrlagigen Schichtstruktur die alternierende Schichten A und B umfasst, mit A Schichten mit der Zusammensetzung in Atomprozent $Me_{ApA}O_{nA}N_{mA}$ und B Schichten mit der Zusammensetzung in Atomprozent $Me_{BpB}O_{nB}N_{mB}$, wobei

a. die Wärmeleitfähigkeit der A Schichten grösser als die Wärmeleitfähigkeit der B Schichten ist,
b. $Me_A$ und $Me_B$ jeweils zumindest ein Metall der Gruppe Ti und Cr umfassen,
c. pA die Atomprozente von MeA bezeichnet und pB die Atomprozente von MeB bezeichnet und Folgendes gilt: $p_A = p_B$,

d. nA die Sauerstoffkonzentration in den A Schichten in Atomprozent bezeichnet und nB die Sauerstoffkonzentration in den B Schichten in Atom prozent bezeichnet und Folgendes gilt: $n_A < n_B$,

e. mA die Stickstoffkonzentration in den A Schichten in Atomprozent bezeichnet und mB die Stickstoffkonzentration in den B Schichten in Atom prozent bezeichnet und Folgendes gilt: $p_A/(n_A+m_A) = p_B/(n_B+m_B)$,

f.

$$Me_A = Me_B,$$

und

g. $5\% \le n_B \le 30\%$ unter Beachtung, dass $p_A+n_A+m_A = p_B+n_B+m_B = 100\%$,

**dadurch gekennzeichnet, dass** zumindest eine A Schicht oder eine B Schicht zumindest einer Teil der Schichtdicke entlang eine gradierte Sauerstoffkonzentration aufweist, oder das Hartstoffschichtsystem zumindest eine weitere Hartstoffschicht des Typs $Me_pO_nN_m$ mit $n \ge 0$, mit $Me = Me_A$ und $p = p_A$ oder mit $Me = Me_B$ und $p = p_B$, als Deckschicht, umfasst, die zumindest ein Teil der Schichtdicke entlang eine gradierte Sauerstoffkonzentration aufweist.

2. Hartstoffschichtsystem nach einem der vorangehenden Ansprüche, **dadurch gekennzeichnet, dass** $n_A = 0\%$.

3. Hartstoffschichtsystem nach einem der vorhergehenden Ansprüche, **dadurch gekennzeichnet, dass** $n_A$ und $n_B$ so ausgewählt sind, dass die A Schichten in Bezug auf Schichthärte und E-Modul sich nicht von den B Schichten unterscheiden.

4. Hartstoffschichtsystem nach einem der vorhergehenden Ansprüche, **dadurch gekennzeichnet, dass** $n_A$ und $n_B$ so ausgewählt sind, dass die A Schichten in Bezug auf Schichtmorphologie, und/oder Korngrösse sich nicht von den B Schichten unterscheiden.

5. Hartstoffschichtsystem nach einem der vorhergehenden Ansprüche, **dadurch gekennzeichnet, dass** $n_A$ und $n_B$ so ausgewählt sind, dass die A Schichten in Bezug auf Phasenbestand und/oder strukturelle Stabilität sich nicht von den B Schichten unterscheiden.

6. Hartstoffschichtsystem nach einem der vorangehenden Ansprüche, **dadurch gekennzeichnet, dass** die Wärmeleitfähigkeit des Hartstoffschichtsystems parallel zur Substratoberfläche grösser als die Wärmeleitfähigkeit des Hartstoffschichtsystems senkrecht zur Substratoberfläche ist.

7. Hartstoffschichtsystem nach einem der vorhergehenden Ansprüche, **dadurch gekennzeichnet, dass** die Härte des Hartstoffschichtsystems grösser 20 GPa ist.

8. Hartstoffschichtsystem nach einem der vorhergehenden Ansprüche, **dadurch gekennzeichnet, dass** zumindest die mehrlagige Schichtstruktur eine kubische Struktur aufweist.

9. Hartstoffschichtsystem nach einem der vorhergehenden Ansprüche, **dadurch gekennzeichnet, dass** $Me_A$ und $Me_B$ zumindest grösstenteils die Metalle Aluminium und/oder Titan, oder die Metalle Aluminium und/oder Chrom umfasst/umfassen.

10. Hartstoffschichtsystem nach dem vorangehenden Anspruch, **dadurch gekennzeichnet, dass** das Konzentrationsverhältnis in Atomprozent von Titan in Bezug auf Aluminium, d.h. Ti/Al oder von Chrom in Bezug auf Aluminium, d.h. Cr/Al kleiner als 1 ist.

11. Bauteil oder Werkzeug beschichtet mit einem Hartstoffschichtsystem nach mindestens einem der vorangehenden Ansprüche.

12. Verwendung eines Werkzeugs nach Anspruch 11 für die spangebende Bearbeitung von schwerzerspanbaren Materialien, wie Ni- und/oder Ti-basierten Legierungen.

13. Methode zur Herstellung einer Metalloxydnitrid-Hartstoffschicht mit einer mehrlagigen Schichtstruktur mit alternierenden Schichten A und B, mit A Schichten mit der Zusammensetzung in Atomprozent $Me_{ApA}O_{nA}N_{mA}$ und B Schichten mit der Zusammensetzung in Atomprozent $Me_{BpB}O_{nB}N_{mB}$ mit einer vorgegebenen, sauerstoffabhängigen Wärmeleitfähigkeit, d.h. mit einer vorgegebenen, sauerstoffabhängigen thermische Leitfähigkeit, wobei

a. die $Me_{ApA}O_{nA}N_{mA}$ Schicht in einer Vakuumbeschichtungskammer durch physikalische Gasphasenabscheidung aus mindestens einem Target in einer reaktivgashaltigen Atmosphäre bei einer Substrattemperatur Ts und einem Beschichtungsdruck P auf einer Substratoberfläche abgeschieden wird,

b. Stickstoff und Sauerstoff als Reaktivgas verwendet werden,

c. das Target $Me_A$ umfasst, und

d. $Me_A$ zumindest ein Metall aus der Gruppe Ti und Cr umfasst, wobei

e. die Sauerstoffkonzentration in der Vakuumbeschichtungskammer während der Abscheidung der $Me_{ApA}O_{nA}N_{mA}$ Schicht so kontrolliert wird, dass ein vorher durch die Korrelation $\kappa(\chi)$ = $\kappa_0$ / $(1+\alpha.\chi)$ berechneter Sauerstoffkonzentrationswert eingehalten wird, damit die vorgegebene sauerstoffabhängige thermische Leitfähigkeit in der $Me_{ApA}O_{nA}N_{mA}$ Schicht während der Schichtabscheidung eingestellt wird, wobei:

    i. $\kappa(\chi)$ die sauerstoffabhängige thermische Leitfähigkeit einer $Me_{ApA}O_{nA}N_{mA}$ Schicht ist, die unter Einhaltung einer Sauerstoffkonzentration in der Vakuumbeschichtungskammer während der Schichtabscheidung produziert wird,

    ii. $\chi$ die Sauerstoffkonzentration ist,

    iii. $\kappa_0$ die thermische Leitfähigkeit einer ersten Referenzschicht $Me_{p0}O_{n0}N_{m0}$ ist, wobei $n_0$=0% und $Me_{p0}O_{n0}N_{m0}$ bei den gleichen Prozessparametern abgeschieden wird, die oben hinsichtlich der Abscheidung der $Me_pO_nN_m$ Schicht beschrieben sind, aber ohne Verwendung von Sauerstoff als Reaktivgas, sondern nur von Stickstoff,

    iv. $\alpha$ ein Parameter ist, der den Streuquerschnitt enthält, und der durch die Anpassung der oben angegebenen Korrelation an experimentalen Daten von zumindest noch einer zweiten Referenzschicht $Me_{p1}O_{n1}N_{m1}$ und noch einer dritten Referenzschicht $Me_{p2}O_{n2}N_{m2}$ geliefert wird, wobei $Me_{p1}O_{n1}N_{m1}$ und $Me_{p2}O_{n2}N_{m2}$ bei den gleichen Prozessparametern abgeschieden werden, die oben hinsichtlich der Abscheidung der $Me_pO_nN_m$ Schicht beschrieben sind, aber unter Verwendung unterschiedlicher Sauerstoffkonzentrationen in der Vakuumbeschichtungskammer,

wobei

f. $Me_{BpB}O_{nB}N_{mB}$ Schicht in einer Vakuumbeschichtungskammer durch physikalische Gasphasenabscheidung aus mindestens einem Target in einer reaktivgashaltigen Atmosphäre bei einer Substrattemperatur Ts und einem Beschichtungsdruck P auf einer Substratoberfläche abgeschieden wird,

g. Stickstoff und Sauerstoff als Reaktivgas verwendet werden,

h. das Target $Me_B$ umfasst, und

i. $Me_B$ zumindest ein Metall aus der Gruppe Ti und Cr umfasst,

wobei

j. die Sauerstoffkonzentration in der Vakuumbeschichtungskammer während der Abscheidung der $Me_{BpB}O_{nB}N_{mB}$ Schicht so kontrolliert wird, dass ein vorher durch die Korrelation $\kappa(\chi)$ = $\kappa_0$ / $(1+\alpha.\chi)$ berechneter Sauerstoffkonzentrationswert eingehalten wird, damit die vorgegebene sauerstoffabhängige thermische Leitfähigkeit in der $Me_{BpB}O_{nB}N_{mB}$ Schicht während der Schichtabscheidung eingestellt wird, wobei:

    v. $\kappa(\chi)$ die sauerstoffabhängige thermische Leitfähigkeit einer $Me_{BpB}O_{nB}N_{mB}$ Schicht ist, die unter Einhaltung einer Sauerstoffkonzentration in der Vakuumbeschichtungskammer während der Schichtabscheidung produziert wird,

    vi. $\chi$ die Sauerstoffkonzentration ist,

    vii. $\kappa_0$ die thermische Leitfähigkeit einer ersten Referenzschicht $Me_{p0}O_{n0}N_{m0}$ ist, wobei $n_0$=0% und $Me_{p0}O_{n0}N_{m0}$ bei den gleichen Prozessparametern abgeschieden wird, die oben hinsichtlich der Abscheidung der $Me_{BpB}O_{nB}N_{mB}$ Schicht beschrieben sind, aber ohne Verwendung von Sauerstoff als Reaktivgas, sondern nur von Stickstoff,

    viii. $\alpha$ ein Parameter ist, der den Streuquerschnitt enthält, und der durch die Anpassung der oben angegebenen Korrelation an experimentalen Daten von zumindest noch einer zweiten Referenzschicht $Me_{p1}O_{n1}N_{m1}$ und noch einer dritten Referenzschicht $Me_{p2}O_{n2}N_{m2}$ geliefert wird, wobei $Me_{p1}O_{n1}N_{m1}$ und $Me_{p2}O_{n2}N_{m2}$ bei den gleichen Prozessparametern abgeschieden werden, die oben hinsichtlich der Abscheidung der $Me_pO_nN_m$ Schicht beschrieben sind, aber unter Verwendung unterschiedlicher Sauerstoffkonzentrationen in der Vakuumbeschichtungskammer,

- wobei die Wärmeleitfähigkeit der A Schichten grösser als die Wärmeleitfähigkeit der B Schichten ist,

- wobei pA die Atomprozente von MeA bezeichnet und pB die Atomprozente von MeB bezeichnet und Folgendes gilt: pA = pB,

- wobei nA die Sauerstoffkonzentration in den A Schichten in Atomprozent bezeichnet und nB die Sauerstoffkonzentration in den B Schichten in Atomprozent bezeichnet und Folgendes gilt: nA < nB,

- wobei mA die Stickstoffkonzentration in den A Schichten in Atomprozent bezeichnet und mB die Stickstoffkonzentration in den B Schichten in Atomprozent bezeichnet und Folgendes gilt: pA/(nA+mA) = pB/(nB+mB),

- wobei MeA = MeB, und

- wobei 5% $\leq$ nB $\leq$ 30% unter Beachtung, dass pA+nA+mA = pB+nB+mB = 100%,

**dadurch gekennzeichnet, dass** zumindest eine A Schicht oder eine B Schicht zumindest einer Teil der Schichtdicke entlang eine gradierte Sauerstoffkonzentration aufweist, oder das Hartstoffschichtsystem zumindest eine weitere Hartstoffschicht des Typs $Me_pO_nN_m$ mit $n \geq 0$, mit $Me = Me_A$ und $p = p_A$ oder mit $Me = Me_B$ und $p = p_B$, als Deckschicht, umfasst, die zumindest ein Teil der Schichtdicke entlang eine gradierte Sauerstoffkonzentration aufweist.

14. Methode zur Herstellung einer Metalloxydnitrid-Hartstoffschicht gemäß Anspruch 13, **dadurch gekennzeichnet, dass** $Me_{p1}O_{n1}N_{m1}$ unter Verwendung einer Sauerstoffkonzentration in der Vakuumbeschichtungskammer abgeschieden wird, die in einer Sauerstoffkonzentration in Atomprozent in der Schicht $n_1$ zwischen 5% und 20 resultiert, während $Me_{p2}O_{n2}N_{m2}$ unter Verwendung einer Sauerstoffkonzentration abgeschieden wird, die in einer in einer Sauerstoffkonzentration in Atomprozent in der Schicht $n_2$ zwischen 20% und 30% resultiert, unter Beachtung, dass $p_0+n_0+m_0=p_1+n_1+m_1=p_2+n_2+m_2=100\%$, $m_1$ und $m_2$ grösser Null sind, $p_0=p_1=p_2$ und $p_0/(n_0+m_0)=p_1/(n_1+m_1)=p_2/(n_2+m_2)$.

**Claims**

1. Hard coating layer system deposited on a substrate surface with a multilayered structure comprising alternating layers A and B, with A layers having the composition in atomic percent $Me_{ApA}O_{nA}N_{mA}$ and B layers having the composition in atomic percent $Me_{BpB}O_{nB}N_{mB}$, wherein

   a. the thermal conductivity of A layers is greater than the thermal conductivity of B layers,
   b. $Me_A$ and $Me_B$ each comprise at least one metal from the group Ti and Cr,
   c. pA denotes the atomic percent of MeA and pB denotes the atomic percent of MeB, and the following holds: pA = pB,
   d. nA denotes the oxygen concentration in A layers in atomic percent, and nB denotes the oxygen concentration in B layers in atomic percent, and the following holds: nA < nB,
   e. mA denotes the nitrogen concentration in A layers in atomic percent, and mB denotes the nitrogen concentration in B layers in atomic percent, and the following holds: $p_A/(n_A+m_A) = p_B/(n_B+m_B)$,
   f.

$$Me_A = Me_B,$$

   and
   g. $5\% \leq n_B \leq 30\%$, with the condition that $p_A+n_A+m_A = p_B+n_B+m_B = 100\%$,

**characterized in that** at least one A layer or one B layer along at least a portion of the layer thickness has a graded oxygen concentration, or the hard coating layer system comprises at least one additional hard coating layer of type $Me_pO_nN_m$ with $n \geq 0$, with $Me = Me_A$ and $p = p_A$ or with $Me = Me_B$ and $p = p_B$, as a cover layer, which has a graded oxygen concentration along at least a portion of the layer thickness.

2. Hard coating layer system according to any of the preceding claims, **characterized in that** $n_A = 0\%$.

3. Hard coating layer system according to any of the preceding claims, **characterized in that** $n_A$ and $n_B$ are selected such that the A layers do not differ from the B layers in terms of layer hardness and E-modulus.

4. Hard coating layer system according to any of the preceding claims, **characterized in that** $n_A$ and $n_B$ are selected such that the A layers do not differ from the B layers in terms of layer morphology and/or grain size.

5. Hard coating layer system according to any of the preceding claims, **characterized in that** $n_A$ and $n_B$ are selected such that the A layers do not differ from the B layers in terms of phase composition and/or structural stability.

6. Hard coating layer system according to any of the preceding claims, **characterized in that** the thermal conductivity of the hard coating layer system parallel to the substrate surface is greater than the thermal conductivity of the hard coating layer system perpendicular to the substrate surface.

7. Hard coating layer system according to any of the preceding claims, **characterized in that** the hardness of the hard coating layer system is greater than 20 GPa.

8. Hard coating layer system according to any of the preceding claims, **characterized in that** at least the multilayered structure has a cubic structure.

9. Hard coating layer system according to one of the preceding claims, **characterized in that** $Me_A$ and $Me_B$ at least mostly comprise the metals aluminum and/or titanium, or the metals aluminum and/or chromium.

10. Hard coating layer system according to the preceding claim, **characterized in that** the concentration ratio in atomic percent of titanium with respect to aluminum, i.e., Ti/Al, or of chromium with respect to aluminum, i.e., Cr/Al, is less than 1.

11. Component or tool coated with a hard coating layer system according to at least one of the preceding claims.

12. Use of a tool according to claim 11 for the machining of difficult-to-cut materials, such as nickel and/or titanium-based alloys.

13. Method for producing a metal oxynitride hard coating layer with a multilayer structure with alternating layers A and B, with A layers having the composition in atomic percent $Me_{ApA}O_{nA}N_{mA}$ and B layers having the composition in atomic percent $Me_{BpB}O_{nB}N_{mB}$ with a predetermined oxygen-dependent conductivity of heat, i.e., with a predetermined oxygen-dependent thermal conductivity, wherein

a. the $Me_{ApA}O_{nA}N_{mA}$ layer is deposited in a vacuum coating chamber by physical vapor deposition from at least one target in a reactive gas-containing atmosphere at a substrate temperature Ts and a coating pressure P on a substrate surface,
b. nitrogen and oxygen are used as reactive gas,
c. the target comprises $Me_A$, and
d. $Me_A$ comprises at least one metal from the group Ti and Cr, wherin
e. the oxygen concentration in the vacuum coating chamber during the deposition of the $Me_{ApA}O_{nA}N_{mA}$ layer is controlled in such a manner that an oxygen concentration value which was in advance calculated by the correlation $\kappa(\chi) = \kappa0 \, / \, (1+\alpha.\chi)$, is maintained, in order to adjust the predetermined oxygen-dependent thermal conductivity in the $Me_{ApA}O_{nA}N_{mA}$ layer during the layer deposition, wherein:

i. $\kappa(\chi)$ is the oxygen-dependent thermal conductivity of a $Me_{ApA}O_{nA}N_{mA}$ layer produced while maintaining an oxygen concentration in the vacuum coating chamber during layer deposition,
ii. $\chi$ is the oxygen concentration,
iii. $\kappa0$ is the thermal conductivity of a first reference layer $Me_{p0}O_{n0}N_{m0}$, where $n_0=0\%$, and $Me_{p0}O_{n0}N_{m0}$ is deposited under the same process parameters as described above regarding the deposition of the $Me_pO_nN_m$ layer, however without using oxygen as a reactive gas, but only using nitrogen,
iv. $\alpha$ is a parameter containing the scattering cross-section, provided by adjusting the above correlation to experimental data from at least one second reference layer $Me_{p1}O_{n1}N_{m1}$ and at least one third reference layer $Me_{p2}O_{n2}N_{m2}$, where $Me_{p1}O_{n1}N_{m1}$ and $Me_{p2}O_{n2}N_{m2}$ are deposited under the same process parameters as described above regarding the deposition of the $Me_pO_nN_m$ layer, however using different oxygen concentrations in the vacuum coating chamber, wherein

f. the $Me_{BpB}O_{nB}N_{mB}$ layer is deposited in a vacuum coating chamber by physical vapor deposition from at least one target in a reactive gas-containing atmosphere at a substrate temperature Ts and a coating pressure P on a substrate surface,
g. nitrogen and oxygen are used as reactive gas,
h. the target comprises $Me_B$
i. $Me_B$ comprises at least one metal from the group Ti and Cr,
wherein
j. the oxygen concentration in the vacuum coating chamber during the deposition of the $Me_{BpB}O_{nB}N_{mB}$ layer is controlled in such a manner that an oxygen concentration value which was in advance calculated by the correlation $\kappa(\chi) = \kappa_0 \, / \, (1+\alpha.\chi)$, is maintained, in order to adjust the predetermined oxygen-dependent thermal conductivity in the $Me_{BpB}O_{nB}N_{mB}$ layer during the layer deposition, wherein:

v. $\kappa(\chi)$ is the oxygen-dependent thermal conductivity of a $Me_{BpB}O_{nB}N_{mB}$ layer produced while maintaining an oxygen concentration in the vacuum coating chamber during layer deposition,
vi. $\chi$ is the oxygen concentration,
vii. $\kappa_0$ is the thermal conductivity of a first reference layer $Me_{p0}O_{n0}N_{m0}$, where $n_0=0\%$, and $Me_{p0}O_{n0}N_{m0}$ is deposited under the same process parameters as described above regarding the deposition of the $Me_{BpB}O_{nB}N_{mB}$ layer, however without using oxygen as a reactive gas, but only using nitrogen,
viii. $\alpha$ is a parameter containing the scattering cross-section, provided by adjusting the above correlation to experimental data from at least one second reference layer $Me_{p1}O_{n1}N_{m1}$ and at least one third reference layer $Me_{p2}O_{n2}N_{m2}$, where $Me_{p1}O_{n1}N_{m1}$ and $Me_{p2}O_{n2}N_{m2}$ are deposited under the same process parameters as described above regarding the deposition of the $Me_pO_nN_m$ layer, however using different oxygen concentrations in the vacuum coating chamber,

- wherein the thermal conductivity of the A layers is greater than the thermal conductivity of the B layers,

- wherein pA represents the atomic percent of MeA and pB represents the atomic percent of MeB, and the following holds: pA = pB,
- wherein nA represents the oxygen concentration in the A layers in atomic percent, and nB represents the oxygen concentration in the B layers in atomic percent, and the following holds: nA < nB,
- wherein mA represents the nitrogen concentration in the A layers in atomic percent, and mB represents the nitrogen concentration in the B layers in atomic percent, and the following holds: $p_A/(n_A+m_A) = p_B/(n_B+m_B)$,
- wherein MeA = MeB, and
- wherein $5\% \leq nB \leq 30\%$, considering that pA+nA+mA = pB+nB+mB = 100%,

**characterized in that** at least one A layer or one B layer has a graded oxygen concentration along at least part of the layer thickness, or the hard coating layer system comprises at least one additional hard coating layer of type $Me_pO_nN_m$ with $n \geq 0$, with Me = $Me_A$ and p = $p_A$ or with Me = $Me_B$ and p = $p_B$, as a cover layer, which has a graded oxygen concentration along at least part of the layer thickness.

14. Method for producing a metal oxynitride hard coating layer according to claim 13, **characterized in that** $Me_{p1}O_{n1}N_{m1}$ is deposited using an oxygen concentration in the vacuum coating chamber resulting in an oxygen concentration in atomic percent in the layer n1 between 5% and 20, while $Me_{p2}O_{n2}N_{m2}$ is deposited using an oxygen concentration resulting in an oxygen concentration in atomic percent in the layer n2 between 20% and 30%, considering that $p_0+n_0+m_0=p_1+n_1+m_1=p_2+n_2+m_2=100\%$, $m_1$ and $m_2$ are greater than zero, $p_0=p_1=p_2$, and $p_0/(n_0+m_0)=p_1/(n_1+m_1)=p_2/(n_2+m_2)$.

**Revendications**

1. Système de revêtement dur déposé sur une surface de substrat avec une structure multicouche comprenant des couches alternées A et B, avec des couches A ayant une composition en pourcentage atomique de $Me_{ApA}O_{nA}N_{mA}$ et des couches B ayant une composition en pourcentage atomique de $Me_{BpB}O_{nB}N_{mB}$, où

    a. la conductivité thermique des couches A est plus grande que la conductivité thermique des couches B,
    b. $Me_A$ et $Me_B$ comprennent chacun au moins un métal du groupe Ti et Cr
    c. pA représente les pourcentages atomiques de MeA et pB représente les pourcentages atomiques de MeB, et il est stipulé que pA = pB

    d. nA représente la concentration d'oxygène dans les couches A en pourcentage atomique, et nB représente la concentration d'oxygène dans les couches B en pourcentage atomique, et il est établi que nA < nB,
    e. mA représente la concentration d'azote dans les couches A en pourcentage atomique, et mB représente la concentration d'azote dans les couches B en pourcentage atomique. Il est établi que pA/(nA+mA) = pB/(nB+mB).
    f.

$$Me_A = Me_B,$$

    et
    g. $5\% \leq nB \leq 30\%$ en tenant compte de la condition que pA+nA+mA = pB+nB+mB = 100%

**caractérisé en ce qu'**au moins une couche A ou une couche B présente sur au moins une partie de son épaisseur une concentration graduelle en oxygène, ou le système de revêtement dur comprend au moins une autre couche dure de type $Me_pO_nN_m$ avec $n \geq 0$, avec Me = $Me_A$ et p = pA ou avec Me = $Me_B$ et p = pB, en tant que couche de recouvrement, qui présente sur au moins une partie de son épaisseur une concentration graduelle en oxygène.

2. Système de revêtement dur selon l'une des revendications précédentes, **caractérisé en ce que** $n_A$ = 0%

3. Système de revêtement dur selon l'une quelconque des revendications précédentes, **caractérisé en ce que** $n_A$ et $n_B$ sont choisis de telle manière que les couches A ne diffèrent pas des couches B en termes de dureté de couche et de module-E.

4. Système de revêtement dur selon l'une quelconque des revendications précédentes, **caractérisé en ce que** $n_A$ et $n_B$ sont choisis de telle manière que les couches A ne diffèrent pas des couches B en termes de morphologie de couche et/ou de taille de grain.

5. Système de revêtement dur selon l'une quelconque des revendications précédentes, **caractérisé en ce que** $n_A$ et $n_B$ sont choisis de telle manière que les couches A ne diffèrent pas des couches B en termes de composition de phase et/ou de stabilité structurelle.

6. Système de revêtement dur selon l'une quelconque des revendications précédentes, **caractérisé en ce que** la conductivité thermique du système de revêtement dur parallèlement à la surface du substrat est plus grande que la conductivité thermique du système de revêtement dur perpendiculairement à la surface du substrat.

**7.** Système de revêtement dur selon l'une quelconque des revendications précédentes, **caractérisé en ce que** la dureté du système de revêtement dur est supérieure à 20 GPa.

**8.** Système de revêtement dur selon l'une quelconque des revendications précédentes, **caractérisé en ce que** la structure multicouche, au moins, présente une structure cubique.

**9.** Système de revêtement dur selon l'une quelconque des revendications précédentes, **caractérisé en ce que** $Me_A$ et $Me_B$ comprennent au moins en grande partie les métaux aluminium et/ou titane, ou les métaux aluminium et/ou chrome.

**10.** Système de revêtement dur selon la revendication précédente, **caractérisé en ce que** le rapport de concentration en pourcentage atomique de titane par rapport à l'aluminium, c'est-à-dire Ti/Al, ou de chrome par rapport à l'aluminium, c'est-à-dire Cr/Al, est inférieur à 1.

**11.** Composant ou outil revêtu d'un système de revêtement dur selon au moins l'une des revendications précédentes.

**12.** Utilisation d'un outil selon la revendication 11 pour l'usinage par enlèvement de copeaux de matériaux difficilement usinables, tels que des alliages à base de Ni et/ou de Ti.

**13.** Procédé de fabrication d'un revêtement dur en nitrure d'oxyde métallique présentant une structure multicouche avec des couches alternées A et B, les couches A ayant une composition en pourcentage atomique $Me_{ApA}O_{nA}N_{mA}$ et les couches B ayant une composition en pourcentage atomique $Me_{BpB}O_{nB}N_{mB}$, avec une conductivité de la chaleur prédéfinie dépendante de l'oxygène, c'est-à-dire avec une conductivité thermique prédéfinie dépendante de l'oxygène, dans lequel...

a. la couche $Me_{ApA}O_{nA}N_{mA}$ est déposée sur une surface de substrat dans une chambre de revêtement sous vide par dépôt physique en phase gazeuse à partir d'au moins une cible dans une atmosphère contenant un gaz réactif, à une température de substrat Ts et une pression de revêtement P.
b. l'azote et l'oxygène sont utilisés comme gaz réactifs
c. la cible comprend MeA, et
d. MeA comprend au moins un métal du groupe Ti et Cr
où

e. la concentration en oxygène dans la chambre de revêtement sous vide pendant le dépôt de la couche $Me_{ApA}O_{nA}N_{mA}$ est contrôlée de manière à respecter une valeur de concentration en oxygène précédemment calculée par la corrélation $\kappa(\chi) = \kappa0 / (1+\alpha\cdot\chi)$, afin d'ajuster la conductivité thermique prédéfinie dépendante de l'oxygène dans la couche $Me_{ApA}O_{nA}N_{mA}$ pendant le dépôt de la couche, où

i. $\kappa(\chi)$ représente la conductivité thermique dépendante de l'oxygène d'une couche MeApAOnANmA produite en respectant une concentration en oxygène dans la chambre de revêtement sous vide pendant le dépôt de la couche.
ii. $\chi$ représente la concentration en oxygène,
iii. $\kappa0$ représente la conductivité thermique d'une première couche de référence $Me_{p0}O_{n0}N_{m0}$, où $n_0=0\%$, et $Me_{p0}O_{n0}N_{m0}$ est déposée avec les mêmes paramètres de processus décrits ci-dessus pour le dépôt de la couche $Me_pO_nN_m$, mais sans utilisation d'oxygène comme gaz réactif, seulement d'azote,
iv. a est un paramètre qui contient la section efficace, et qui est fourni par l'ajustement de la corrélation susmentionnée sur des données expérimentales d'au moins une deuxième couche de référence $Me_{p1}O_{n1}N_{m1}$ et d'au moins une troisième couche de référence $Me_{p2}O_{n2}N_{m2}$, où $Me_{p1}O_{n1}N_{m1}$ et $Me_{p2}O_{n2}N_{m2}$ sont déposées avec les mêmes paramètres de processus décrits ci-dessus pour le dépôt de la couche $Me_pO_nN_m$, mais en utilisant des concentrations différentes d'oxygène dans la chambre de revêtement sous vide,"

où
f. La couche $Me_{BpB}O_{nB}N_{mB}$ est déposée dans une chambre de revêtement sous vide par dépôt physique en phase gazeuse à partir d'au moins une cible dans une atmosphère contenant un gaz réactif, à une température de substrat Ts et une pression de revêtement P, sur une surface de substrat.
g. l'azote et l'oxygène sont utilisés comme gaz réactifs.
h. la cible comprend MeB, et
i. MeB comprend au moins un métal du groupe Ti et Cr,
où
j. la concentration en oxygène dans la chambre de revêtement sous vide pendant le dépôt de la couche $Me_{BpB}O_{nB}N_{mB}$ est contrôlée de manière à respecter une valeur de concentration en oxygène précédemment calculée par la corrélation $\kappa(\chi) = \kappa_0 / (1+\alpha \cdot \chi)$, afin d'ajuster la conductivité thermique prédéfinie dépendante de l'oxygène dans la couche $Me_{BpB}O_{nB}N_{mB}$ pendant le dépôt de la couche, où :

v. $\kappa(\chi)$ représente la conductivité thermique dépendante de l'oxygène d'une couche $Me_{BpB}O_{nB}N_{mB}$ produite en respectant une concentration en oxygène dans la chambre de revêtement sous vide pendant le dépôt de la couche.

vi. $\chi$ représente la concentration en oxygène."

vii. $\kappa_0$ représente la conductivité thermique d'une première couche de référence $Me_{p0}O_{n0}N_{m0}$, où $n_0=0\%$, et $Me_{p0}O_{n0}N_{m0}$ est déposée avec les mêmes paramètres de processus décrits ci-dessus pour le dépôt de la couche $Me_{BpB}O_{nB}N_{mB}$, mais sans utilisation d'oxygène comme gaz réactif, seulement d'azote,

viii. $\alpha$ est un paramètre qui contient la section efficace, et qui est fourni par l'ajustement de la corrélation susmentionnée sur des données expérimentales d'au moins une deuxième couche de référence $Me_{p1}O_{n1}N_{m1}$ et d'au moins une troisième couche de référence $Me_{p2}O_{n2}N_{m2}$, où $Me_{p1}O_{n1}N_{m1}$ et $Me_{p2}O_{n2}N_{m2}$ sont déposées avec les mêmes paramètres de processus décrits ci-dessus pour le dépôt de la couche $Me_pO_nN_m$, mais en utilisant des concentrations différentes d'oxygène dans la chambre de revêtement sous vide,

- où la conductivité thermique des couches A est plus grande que la conductivité thermique des couches B,
- où pA représente les pourcentages atomiques de MeA et pB représente les pourcentages atomiques de MeB, et il est stipulé que pA = pB
- où nA représente la concentration d'oxygène dans les couches A en pourcentage atomique et nB représente la concentration d'oxygène dans les couches B en pourcentage atomique, et il est établi que nA < nB,
- où mA représente la concentration d'azote dans les couches A en pourcentage atomique et mB représente la concentration d'azote dans les couches B en pourcentage atomique, et il est établi que pA/(nA+mA) = pB/(nB+mB),
- où MeA = MeB, et
- où $5\% \leq nB \leq 30\%$ en tenant compte de la condition que pA+nA+mA = pB+nB+mB = 100%

**caractérisé en ce qu'**au moins une couche A ou une couche B présente sur au moins une partie de son épaisseur une concentration graduelle en oxygène, ou le système de revêtement dur comprend au moins une autre couche dure de type $Me_pO_nN_m$ avec n $\geq$ 0, avec Me = $Me_A$ et p = pA ou avec Me = $Me_B$ et p = pB, en tant que couche de recouvrement, qui présente sur au moins une partie de son épaisseur une concentration graduelle en oxygène.

**14.** Procédé de fabrication d'un revêtement dur en nitrure d'oxyde métallique selon la revendication 13, **caractérisé en ce que** $Me_{p1}O_{n1}N_{m1}$ est déposé en utilisant une concentration en oxygène dans la chambre de revêtement sous vide, résultant en une concentration en oxygène en pourcentage atomique dans la couche n1 entre 5% et 20, tandis que $Me_{p2}O_{n2}N_{m2}$ est déposé en utilisant une concentration en oxygène résultant en une concentration en oxygène en pourcentage atomique dans la couche n2 entre 20% et 30%, en tenant compte que p0+n0+m0=p1+n1+m1=p2+n2+m2=100%, m1 et m2 sont supérieurs à zéro, p0=p1=p2 et p0/(n0+m0)=p1/(n1+m1)=p2/(n2+m2).

* Gemäss dem funktionalen Zusammenhang zwischen Sauerstoffkonzentration und thermische Leitfähigkeit

Figur 1

* Gemäss dem funktionalen Zusammenhang zwischen Sauerstoffkonzentration und thermische Leitfähigkeit

Figur 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2012192513 A
- JP 2009167498 A
- CN 102586731 A